# EUROPÄISCHE PATENTSCHRIFT

(11) **EP 1 835 528 B1**
(45) Veröffentlichungstag und Bekanntmachung des Hinweises auf die Patenterteilung: **01.02.2012**
(21) Anmeldenummer: 06007759.1
(22) Anmeldetag: 13.04.2006
(51) Int. Cl.: H01L 21/28, H01L 21/338, H01L 29/423, H01L 29/812

(54) **Verfahren zur Herstellung eines Halbleiterbauelements mit einer metallischen Steuerelektrode und Halbleiterbauelement**
Process for fabricating a semiconductor device with metallic gate and semiconductor device
Procédé de fabrication d'un dispositif semi-conducteur avec une grille métallique et dispositif semi-conducteur

(30) Priorität: 17.03.2006 DE 102006012369
(43) Veröffentlichungstag der Anmeldung: 19.09.2007
(73) Patentinhaber: United Monolithic Semiconductors GmbH, 89081 Ulm (DE)
(72) Erfinder: Behammer, Dag, 89079 Ulm (DE); Ilgen, Michael Peter, 89075 Ulm (DE)
(74) Vertreter: Weber, Gerhard

(56) Entgegenhaltungen:
- EP-A- 1 564 801
- US-A- 4 679 311
- US-A- 6 011 281
- US-A1- 2005 023 555
- US-A1- 2005 051 804

## Beschreibung

Die Erfindung betrifft ein Verfahren zur Herstellung eines Halbleiterbauelements mit einer metallischen Steuerelektrode und ein Halbleiterbauelement mit einer metallischen Steuerelektrode, wobei die metallische Steuerelektrode als eine Gateelektrode eines Feldeffekttransistors einen schmäleren Gatefuß und einen breiteren Gatekopf aufweist und typischerweise annähernd T-förmig ist.

Bei monolithisch integrierten Schaltungen mit Feldeffekttransistoren, insbesondere HEMT Hochleistungsfeldeffektransistoren ist die Gatelänge des Gates als Steuerelektrode von besonderer Bedeutung, wobei insbesondere die präzise Herstellung von sehr kleinen Gatelängen unter 300 nm kritisch ist. Die Materialkombination von Metall der Steuerelektrode Halbleitermaterial ist aufgrund von Legierungsbildung, Diffusion, chemischer Reaktion und Beeinflussung der Halbleitereigenschaften von wesentlicher Bedeutung, wobei häufig auf Si-Substraten geeignete Elektrodenmetalle für Verbindungshalbleitermaterialien, insbesondere GaAs und InP nicht geeignet sind und umgekehrt.

Insbesondere bei Bauelementen auf GaAs-Substrat ist Aluminium als Gatematerial von Vorteil gegenüber den häufig eingesetzten Ti/Pt/Au-Steuerelektroden. Aluminium besitzt eine besonders hohe Leitfähigkeit und bildet eine besonders langzeitstabile Verbindung zu dem Halbleitermaterial, ohne dessen Eigenschaften durch Diffusion zu beeinträchtigen.

Aus der DE 103 04 722 A1 ist eine Steuerelektrode aus Aluminium bekannt, bei welcher Aluminium ganzflächig abgeschieden und der Gatekopf durch nachfolgende Markierung und Ätzung aus der durchgehenden Metallschicht hergestellt wird. In anderer häufig angewandter Lift-off-Technik wird eine Struktur für einen Gatekopf in einer Maske vorgegeben, wobei vorteilhafterweise Gatefuß und Gatekopf selbstjustierend zueinander ausgerichtet werden.

Nach dem Abscheiden des Gatemetalls wird wenigstens eine Temperaturbehandlung bei erhöhter Temperatur erforderlich.

In der US 6 011 281 ist ein Feldeffekttransistor beschrieben, bei welchem die Gateelektrode auf einer GaAs-Halbleiterschicht einen Schottky-Kontakt bildet und mehrschichtig aufgebaut ist mit einer Al-Schicht auf der Halbleiterschicht, einer Schichtenfolge aus ersten Ti-Schicht, einer Ti-Haftschicht und einer TiN-Diffusionsbarriere auf der Al-Schicht und einer Verdrahtungsschicht aus Gold auf der TiN-Schicht. Typische Schichtdicken sind 700 nm für die Al-Schicht, je 5 nm für die erste Ti-Schicht und die Ti-Haftschicht, 10 nm für die TiN-Schicht und 3000 nm für die Goldschicht. Die TiN-Schicht unterdrückt die Diffusion von Al in die Goldschicht. Die Ti-Schichten zwischen der TiN-Schicht und der Al-Schicht verhindern eine Diffusion von N aus der TiN-Schicht und eine dadurch bewirkte Nitrierung des Aluminiums.

Die US 4 679 311 beschreibt ein Verfahren zur selbstjustierenden Herstellung eines Feldeffekttransistors, bei welchem eine mehrschichtige Gate-Elektrode mit einer Al-Schicht auf dem Halbleitermaterial, einer Ti-Zwischenschicht und einer AuGeNi-Verdrahtungsschicht. Um eine Oxidierung der Ti-Schicht zu vermeiden, kann auf dieser eine Pt-Schicht abgeschieden werden. Die Ti-Schicht verhindert die Reaktion des Al mit Pt. Die Schichtdicken betragen mindestens 300 nm für die Al-Schicht und mindestens 100 nm für die Ti- und die Pt-Schicht. Zur Herstellung guter ohmscher Kontakte an den Drain- und SourceElektroden wird eine Temperaturbehandlung durchgeführt.

Es zeigt sich aber, dass mit abnehmender Gatelänge die Feldeffekttransistoren mit Al-Gate zu sogenannten NOPO (NO Pinch Off)-Fehlern neigen, durch welche die Bauelemente für viele Anwendungen unbrauchbar werden.

Aufgabe der vorliegenden Erfindung ist es, ein Verfahren zur Herstellung eines Halbleiterbauelements und ein Halbleiterelement auf einen III-V-Verbindungshalbleitersubstrat anzugeben, welches auch bei kleiner Gatelänge günstige und langzeitstabile Eigenschaften besitzt.

Erfindungsgemäße Lösungen sind in den unabhängigen Ansprüchen beschrieben. Die abhängigen Ansprüche enthalten vorteilhafte Ausgestaltungen der Erfindung.

Bei der Erfindung werden die vorteilhaften Eigenschaften des Kontakts zwischen Aluminium (Al) als Material einer ersten Schicht des Gatefußes einerseits und dem Verbindungs-Halbleitermaterial der Halbleiterschicht, insbesondere auf GaAs-Substrat erhalte. Als die Halbleiterschicht sei dabei und im folgenden, soweit nicht explizit oder aus dem Zusammenhang anders angegeben, diejenige Halbleiterschicht benannt, auf welcher die Steuerelektrode aufgebaut und angeordnet ist. Die Steuerelektrode kann insbesondere eine Schottky-Diode mit der Halbleiterschicht bilden. Durch die Einfügung einer zweiten Schicht aus anderem Metall lassen sich vorteilhafterweise auch bei sehr kleinen Gatelängen die NOPO-Fehler vermeiden und günstige langzeitstabile Eigenschaften des Feldeffekttransistors erreichen.

Die Erfindung macht sich die Erkenntnis zunutze, dass wesentlicher Grund für das Auftreten der genannten NOPO-Fehler ein bei der Temperaturbehandlung und/oder im Betrieb durch Elektromigration stattfindendes Korngrößenwachstum des Aluminiums ist. Eine größere Korngröße in Aluminium als Gatemetall ist an sich vorteilhaft für einen geringen elektrischen Widerstand der Gate-Steuerelektrode. Es zeigt sich aber, dass bei abnehmender Gatelänge eine größere Korngröße in dem schmalen Gatefuß sich nachteilig auswirkt.

Dieser nachteiligen Erscheinung wird gemäß der Erfindung entgegen gewirkt, indem in einer dünnen ersten Schicht mit einer ersten Schichtdicke Aluminium mit seinen vorteilhaften physikalischen Eigenschaften als Gatemetall eingesetzt wird und durch die Begrenzung der ersten Schichtdicke durch eine zweite Schicht aus einem von Aluminium verschiedenen zweiten Metall das Korngrößenwachstum in der ersten Schicht auf kleinere mittlere Korngrößen begrenzt wird als bei einem ganz aus Aluminium bestehenden Gate.

Für die zweite Schicht wird vorteilhafterweise ein Metall gewählt, welches mit dem Aluminium der ersten Schicht legierbar ist und bei einer nach der Abscheidung des Metalls der Gateelektrode durchgeführten Temperaturbehandlung, vorzugsweise bei ca. 400°C, an der Schichtgrenze zwischen erster und zweiter Schicht mit dem Al der ersten Schicht legiert wird. Die sich dabei ergebende Legierungsschicht ist vorteilhafterweise von der Halbleiterschicht ausreichend beabstandet, um Beeinträchtigungen der Eigenschaften des Metall-Halbleiterübergangs zuverlässig zu vermeiden.

Als zweites Metall in der zweiten Schicht wird vorteilhafterweise Platin (Pt), Nikkel (Ni) oder vorzugsweise Titan (Ti) auf die erste Schicht abgeschieden. Die zweite Schichtdicke beträgt vorteilhafterweise weniger als 10 nm, insbesondere weniger als 5 nm, vorzugsweise weniger als 2,5 nm.

Vorteilhafterweise wird auf der zweiten Schicht weiteres Gatemetall, welches von dem Metall der zweiten Schicht verschieden ist, in wenigstens einer weiteren Schicht abgeschieden. Vorteilhafterweise besteht der Gatekopf zumindest überwiegend aus dem weiteren Metall. Das weitere Metall wird vorzugsweise in einer Schichtdicke abgeschieden, welche größer ist als die Summe der ersten und zweiten Schichtdicke.

Als weiteres Metall wird vorteilhafterweise Aluminium eingesetzt. Hierdurch wird vermieden, dass anderes Metall aus der weiteren Schicht durch die dünne zweite Schicht in Richtung der ersten Schicht und der Halbleiterschicht diffundiert und dadurch eine nachteilige Beeinflussung der Bauelementeigenschaften eintritt. Die mittlere Korngröße des Aluminiums nach der Temperaturbehandlung ist in der ersten Schicht vorteilhafterweise kleiner als in der weiteren Schicht und beträgt vorzugsweise weniger als 50 %, insbesondere weniger als 20 % der mittleren Korngröße in der weiteren Schicht.

Die Abscheidung des Gatemetalls erfolgt vorzugsweise durch Aufdampfen. Die Strukturierung des Gatekopfes erfolgt vorteilhafterweise selbstjustierend zum Gatefuß. Die größte Ausdehnung des Gatekopfes in Richtung der Gatelänge beträgt vorzugsweise wenigstens das 1,5-fache der Gatelänge und kann typischerweise bis zu ca. 600 nm betragen. Die größte Ausdehnung des Gatekopfes in Richtung der Gatelänge ist vorteilhafterweise um wenigstens 100 nm größer als die Gatelänge. die Gatelänge kann bis auf c. 20 nm verringert werden.

Der Gatefuß wird vorteilhafterweise in einen Recessgraben der Halbleiteroberfläche abgeschieden, wofür vorzugsweise in einer auf dem Halbleitermaterial abgeschiedenen Schicht eine Öffnung mit der Struktur des Gates und mit seitlicher Unterätzung erzeugt ist. Die Schichtdicke der ersten Schicht beträgt vorteilhafterweise wenigstens 50 %, insbesondere wenigstens 65 %, vorzugsweise wenigstens 75 % der Tiefe des Recessgrabens, wodurch insbesondere bei Verwendung von Ti als zweitem Metall nachteilige Effekte durch anderes Aufdampfverhalten des Ti vermieden oder gering gehalten werden können.

Die Erfindung ist nachfolgend anhand bevorzugter Ausführungsbeispiele unter Bezugnahme auf die Abbildungen noch eingehend veranschaulicht. Dabei zeigt:
- Fig. 1: einen Verfahrensablauf in mehreren Schritten,
- Fig. 2: einen vergrößerten Ausschnitt aus Fig. 1d.

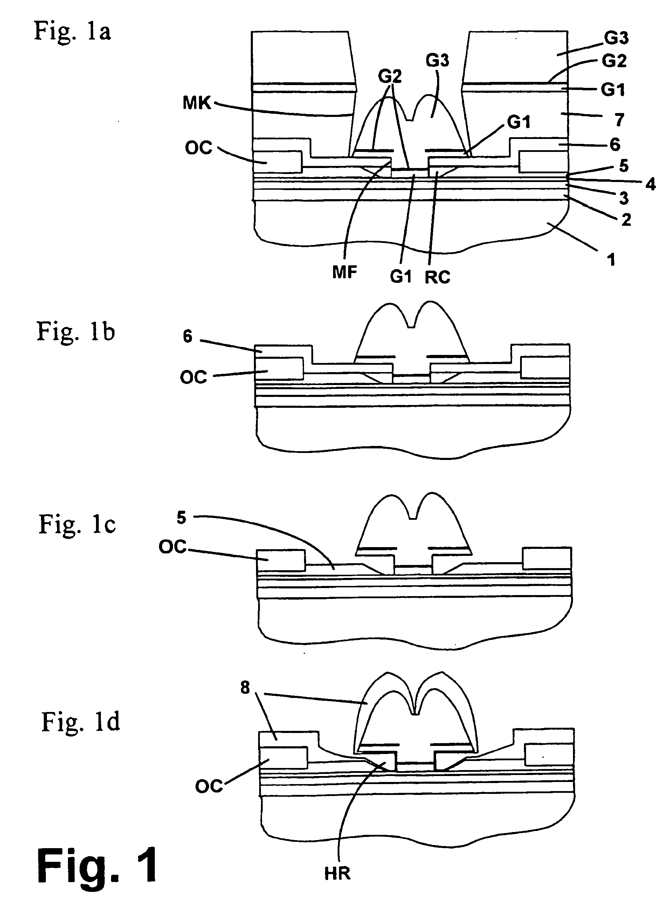

In Fig. 1a bis Fig. 1d sind verschiedene Prozessstadien für die Herstellung einer Steuerelektrode skizziert. Ausgehend von einem GaAs-Substrat 1 bilden die Schichten 2 bis 5 das Vertikalprofil eines Feldeffekttransistors. Für die Schichtenfolge sind aus dem Stand der Technik eine Vielzahl von Beispielen bekannt. Die Anzahl der Schichten, die Schichtendicke und die Zusammensetzung der Materialien kann im Einzelfall variieren.

Typischerweise stellt die Schicht 2 eine Pufferschicht dar, die Schicht 3 bildet eine Halbleiterschicht mit dem zweidimensionalen Elektronengas (den Kanal), die Schicht 4 ist eine Barrierenschicht und bildet die Halbleiterschicht, auf welcher das Metall der Steuerelektrode abgeschieden wird und die mit der Steuerelektrode eine Schottky-Diode bildet, und die Schicht 5 eine hochdotierte Kontaktschicht zur niederohmigen Bauelementkontaktierung über ohmsche Kontakte OC. Insbesondere die Schicht 4 kann in ihrer oben liegenden, d. h. vom Substrat weg weisenden Schichtgrenze eine Stoppschicht als Ätzstopp für Ätzverfahren im Verlauf der Herstellung des Bauelements aufweisen.

Die Schicht 5 besteht vorzugsweise aus GaAs und gegebenenfalls vorhandene Stoppschichten bestehen beispielsweise aus AlAs oder InGaP.

Nach Herstellung der Schichtenfolge 2 bis 5 auf dem Substrat 1 und Erzeugung der ohmschen Kontakte OC wird eine Schutzschicht 6, beispielsweise aus Siliziumdioxyd und/oder Siliziumnitrid ganzflächig abgeschieden.

Auf der Schutzschicht 6 wird eine Schicht aus Fotolack oder ähnlichem Material abgeschieden, in welcher fotolithografisch die Gatestruktur erzeugt wird. Mit der strukturierten Schicht 7 als Maske wird in der Schutzschicht 6 eine Öffnung MF erzeugt, welche die Struktur des Gatefußes bestimmt. Eine Öffnung MK in der Fotolackschicht 7 bestimmt die Struktur des Gatekopfes der Steuerelektrode. Die Öffnung MF in der Schutzschicht 6 und die Öffnung MK in der Fotolackschicht 7 können durch separate photolithografische Schritte oder mit nur einem photolithografischen Schritt selbstjustierend erzeugt werden. Durch die Öffnung MF in der Schutzschicht 6 wird mit seitlicher Unterätzung der Schutzschicht 6 in die Kontaktschicht 5 ein sich zu beiden Seiten der Öffnung MF erstreckender Recessgraben RC erzeugt. Die Tiefe des Recessgrabens entspricht dabei der Schichthöhe der Kontaktschicht 5. Das Gatemetall wird durch Kathodenzerstäubung oder vorzugsweise durch Aufdampfen durch die Öffnung MF auf die Barrierenschicht 4 und durch die Öffnung MK auf die Schutzschicht 6 abgeschieden, wobei eine annähernd T-förmige Elektrode mit einem schmäleren Gatefuß und einem breiteren Gatekopf entsteht. Das abgeschiedene Gatemetall wird auch in der Umgebung des Gatekopfes auf die Fotolackschicht abgeschieden und kann von dort in einem Lift-Off-Verfahren auf günstige Weise entfernt werden.

Das bis dahin beschriebene Verfahren ist in einer Vielzahl von Varianten prinzipiell aus dem Stand der Technik bekannt, wobei anstelle des Lift-Off-Verfahrens insbesondere auch eine Strukturierung des Gatekopfes aus einer durchgehenden Metallschicht durch Ätzen vorgenommen werden kann, wie aus dem in der Beschreibungseinleitung genannten Stand der Technik gleichfalls an sich bekannt ist.

Bei der Abscheidung des Gatemetalls nach dem bevorzugten Beispiel der vorliegenden Erfindung werden nacheinander eine erste Schicht G1 aus Al, auf dieser eine zweite Schicht G2 aus Pt, Ni oder vorzugsweise Ti und wiederum auf dieser eine weitere Schicht G3 aus Al abgeschieden. Bei Strukturierung des Gatekopfes durch Ätzen einer durchgehenden Metallschicht ist Ti auch durch dessen bessere Ätzbarkeit bevorzugt.

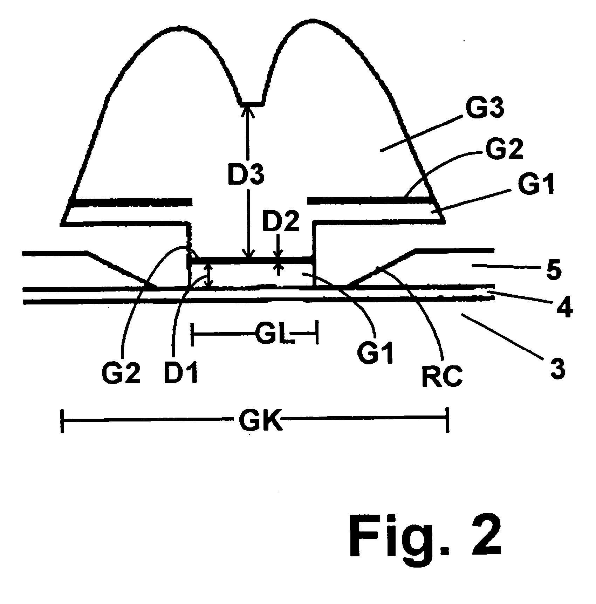

Nach vollständigem Abscheiden des Gatemetalls gemäss Fig. 1a wird durch Lift-Off mit Auflösen der Fotolackschicht 7 das auf dieser abgeschiedene Metall entfernt und es entsteht die Struktur nach Fig. 1 b. In dieser Situation wird typischerweise eine erste Temperaturbehandlung bei erhöhter Temperatur, beispielsweise bei ca. 400°C durchgeführt. Im Rahmen dieser Temperaturbe-handlung tritt ein Korngrößenwachstum des Aluminiums in Schichten G1 und G3 auf, wobei das Korngrößenwachstum in der Schicht G1 durch die gemäss der vorliegenden Erfindung getroffenen Maßnahmen, insbesondere der Begrenzung der Schichtdicke D1 (Fig. 2) der Schicht G1 auf kleinere Korngrößen begrenzt wird als in der Schicht G3.

Danach wird die Schutzschicht 6 entfernt und die in Fig. 1c freigelegte Bauelementstruktur wird mit einer Passivierungsschicht 8 gemäss Fig. 1d überzogen. Das Aufbringen dieser Passivierungsschicht auf eine Bauelementoberfläche ist an sich bekannt.

Wesentlich für die vorliegende Erfindung ist der Schichtaufbau der metallischen Gateelektrode aus im skizzierten Beispiel einer ersten Schicht G1 auf dem Halbleitermaterial der Halbleiterschicht 4 im Recessgraben RC, einer zweiten Schicht G2 auf der ersten Schicht und einer weiteren Schicht G3 auf der zweiten Schicht G2. Die Schichtenfolge findet sich sowohl im Gatefuß über dem Halbleitermaterial im Recessgraben als auch im Gatekopf über der Schutzschicht seitlich der Öffnung MF. Die Proportionen der einzelnen Schichten und/oder der Steuerelektrode in den Figuren sind nicht streng maßstäblich zu verstehen.

Die Schicht G1 besteht aus Aluminium, welches in besonders vorteilhafter Weise eine Grenzfläche zu dem Material der Halbleiterschicht 4 ausbildet und mit dieser insbesondere eine Schottky-Diode bilden kann. Die Schicht 1 wird mit einer Schichtdicke D1 abgeschieden, welche vorteilhafterweise nicht größer ist als das 1,5-fache der Gatelänge GL, insbesondere nicht größer als die Gatelänge GL der Steuerelektrode, siehe Fig. 2. Die Schicht G1 findet sich auch seitlich der Öffnung MF und innerhalb der Öffnung MK auf der oberen Fläche der Schutzschicht 6 mit einer Breite GK des Gatekopfes parallel zur Richtung der Gatelänge.

Die Gatelänge GL liegt vorteilhafterweise unter 300 nm, insbesondere in einem Bereich zwischen 20 nm und 300 nm. Die Breite GK des Gatekopfes ist größer als die Gatelänge GL und beträgt vorzugsweise wenigstens das 1,5-fache der Gatelänge GL. Vorteilhafterweise liegt die Breite GK des Gatekopfes zwischen 400 nm und 650 nm.

Die Dicke D1 der ersten Schicht G1 senkrecht zur Ebene der Halbleiterschichten liegt vorteilhafterweise zwischen 10 nm und 100 nm. Insbesondere bei der bevorzugten Verwendung von Ti als Metall einer auf der ersten Schicht abgeschiedenen zweiten Schicht beträgt die Schichtdicke D1 der ersten Schicht vorteilhafterweise wenigstens 50 %, insbesondere wenigstens 65 %, vorzugsweise wenigstens 75 % der Tiefe des Recessgrabens RC unter der Schutzschicht 6. Die Tiefe des Recessgrabens ist zumindest annähernd gleich der Schichtdicke der Kontaktschicht 5. Durch einen geringen Abstand der oberen Schichtgrenze der ersten Schicht zu der Öffnung MF in der Schutzschicht 6 kann Eindringen von mit größerer Divergenz aufdampfenden Ti in den Recessgraben vermieden oder gering gehalten werden. Die erste Schicht kann auch bis in die Öffnung MF reichen.

Auf die erste Schicht G1 wird durch die Öffnung MF und durch die Öffnung MK eine zweite Schicht G2 aus einem zweiten Metall (oder Metallgemisch) abgeschieden. Das zweite Metall ist von Aluminium verschieden und besitzt vorteilhafterweise die Eigenschaft mit Al legierbar zu sein und das Korngrößenwachstum von Aluminium in der Schicht G1 bei einer späteren Temperaturbehandlung und/oder im Betrieb durch Elektromigration zu begrenzen. Geeignet sind beispielsweise Pt, Ni oder insbesondere Ti. Eine Begrenzung des Kornwachstums ergibt sich insbesondere dadurch, dass Körner in der Aluminiumschicht G1 nach allen Seiten gleichzeitig wachsen und ein Stopp des Korngrößenwachstums an der Schichtgrenze von G1 zu G2 im wesentlichen auch einen Stopp des Korngrößenwachstums quer zu der Schichtgrenzenebene nach sich zieht. Von Bedeutung ist damit insbesondere die geringe Schichtdicke der Schicht G 1.

Die zweite Schichtdicke D2 der zweiten Schicht G2 beträgt vorteilhafterweise weniger als 10 nm, insbesondere weniger als 5 nm, vorzugsweise weniger als 2,5 nm. Auf der zweiten Schicht G2 wird weiteres Gatemetall in wenigstens einer weiteren Schicht, vorzugsweise genau einer weiteren Schicht G3 abgeschieden. Die Abscheidung des weiteren Gatemetalls in der Schicht G3 erfolgt in einer Schichtdicke D3, welche vorteilhafterweise größer ist als die Summe der ersten und zweiten Schichtdicken, G1 und G2. Der Gatekopf besteht vorteilhafterweise überwiegend aus dem weiteren Gatemetall in der weiteren Schicht G3.

Die weitere Schicht G3 besteht aus Aluminium als weiterem Gatemetall. Dieses weist vorteilhafterweise einen sehr geringen spezifischen elektrischen Widerstand auf.

Durch eine nachfolgende Temperaturbehandlung, vorteilhafterweise bei ca. 400°C und/oder im Betrieb des Bauelements durch Elektromigration tritt auch in dem Aluminium der weiteren Schicht G3 ein Korngrößenwachstum auf. Hierbei sind aber keine Maßnahmen erforderlich oder vorgesehen, das Korngrößenwachstum zu begrenzen. Größere Korngrößen können günstig sein bezüglich des elektrischen Widerstands des Gatefadens, welcher senkrecht zur Zeichenebene steht. Vorteilhafterweise ergibt sich nach der Temperaturbehandlung in der ersten Schicht G1 eine mittlere Korngröße des Aluminiums, welche geringer ist als die mittlere Korngröße des Aluminiums in der weiteren Schicht G3 und vorteilhafterweise weniger als 50 %, insbesondere weniger als 20 % der mittleren Korngröße des Aluminiums in der weiteren Schicht G3 beträgt.

Bei der Temperaturbehandlung tritt auch an den Grenzflächen der zweiten Schicht G2 zu der ersten Schicht G1 und der dritten Schicht G1 eine Legierungsbildung der verschiedenen Metalle auf. Eine sich in der ersten Schicht ausbildende Legierungszone geht vorteilhafterweise nicht bis zu der Halbleiterschicht 4 und ist von dieser ausreichend beabstandet, so dass die Eigenschaften des Schottky-Übergangs zwischen der ersten Schicht G1 der Steuerelektrode und der Halbleiterschicht 4 durch die Legierung nicht beeinträchtigt werden.

Anstelle eines GaAs-Substrats kann auch ein InP-Substrat vorgesehen sein.

## Patentansprüche

1. Verfahren zur Herstellung eines Halbleiterbauelements mit einer auf einer Halbleiterschicht (4) auf einem Verbindungs-Halbleiter-Substrat (1) abgeschiedenen metallischen Gateelektrode mit einem Gatefuß und einem Gatekopf, wobei
- eine erste Schicht (G1) der Gateelektrode auf der Halbleiterschicht (4) aus Aluminium hergestellt wird,
- auf der ersten Schicht (G1) eine zweite Schicht (G2) aus einem zweiten Metall abgeschieden wird,
- als weiteres, von dem zweiten Metall verschiedenes Metall zumindest überwiegend Aluminium in wenigstens einer weiteren Schicht (G3) auf der zweiten Schicht abgeschieden wird, und
- nach dem Abscheiden des Metalls der Gateelektrode eine Temperaturbehandlung bei erhöhter Temperatur durchgeführt wird, bei welcher in dem Aluminium ein Korngrößenwachstum auftritt und das Wachstum der Korngrößen des Aluminiums in der ersten Schicht durch das Metall der zweiten Schicht auf eine mittlere Korngröße begrenzt wird, die geringer ist als die mittlere Korngröße in der weiteren Schicht.

2. Verfahren nach Anspruch 1, **dadurch gekennzeichnet, dass** die erste Schicht mit einer ersten Schichtdicke (D1) abgeschieden wird, welche nicht mehr als das 1,5-fache der Gatelänge, insbesondere nicht mehr als die Gatelänge selbst beträgt.

3. Verfahren nach Anspruch 1 oder 2, **dadurch gekennzeichnet, dass** die erste Schicht mit einer ersten Schichtdicke (D1) zwischen 10 nm und 100 nm abgeschieden wird.

4. Verfahren nach einem der Ansprüche 1 bis 3, **dadurch gekennzeichnet, dass** für die zweite Schicht ein Metall gewählt wird, welches mit Al eine Legierung bilden kann, und dass bei der Temperaturbehandlung Al und das Metall der zweiten Schicht an der Grenzfläche von erster und zweiter Schicht legiert werden.

5. Verfahren nach Anspruch 4, **dadurch gekennzeichnet, dass** die zweite Schicht (G2) aus Ti, Ni oder Pt hergestellt wird.

6. Verfahren nach einem der Ansprüche 1 bis 5, **dadurch gekennzeichnet, dass** die zweite Schicht (G2) mit einer zweiten Schichtdicke (D2) abgeschieden wird, welche geringer ist als die erste Schichtdicke (D1).

7. Verfahren nach Anspruch 6, **dadurch gekennzeichnet, dass** die zweite Schicht mit einer Schichtdicke (D2) von weniger als 10 nm, insbesondere weniger als 5 nm, vorzugsweise weniger als 2,5 nm abgeschieden wird.

8. Verfahren nach einem der Ansprüche 1 bis 7, **dadurch gekennzeichnet, dass** der Gatekopf überwiegend aus dem weiteren Metall hergestellt wird.

9. Verfahren nach einem der Ansprüche 1 bis 8, **dadurch gekennzeichnet, dass** das weitere Metall in einer Schichtdicke (D3) abgeschieden wird, welche größer ist als die Summe von erster und zweiter Schichtdicke (D1,D2).

10. verfahren nach einem der Ansprüche 1 bis 9, **dadurch gekennzeichnet, dass** als weiteres Metall ausschließlich Aluminium abgeschieden wird.

11. Verfahren nach einem der Ansprüche 1 bis 10, **dadurch gekennzeichnet, dass** die mehreren metallischen Schichten (G1,G2,G3) der Gateelektrode durch Aufdampfen oder Kathodenzerstäubung abgeschieden werden.

12. verfahren nach einem der Ansprüche 1 bis 11, **dadurch gekennzeichnet, dass** der Gatefuß durch eine Öffnung (MF) einer unterätzten Schicht in einem Recessgraben (RC) abgeschieden wird.

13. Verfahren nach Anspruch 12, **dadurch gekennzeichnet, dass** die erste Schicht mit einer ersten Schichtdicke abgeschieden wird, welche wenigstens 50 %, insbesondere wenigstens 65 %, vorzugsweise wenigstens 75 % der Tiefe (DR) des Recessgrabens (RC) beträgt.

14. Verfahren nach einem der Ansprüche 11 bis 13, **dadurch gekennzeichnet, dass** der Gatekopf im lift-off-Verfahren hergestellt wird.

15. Halbleiterbauelement mit einer metallischen Gateelektrode auf einer Halbleiterschicht aus Halbleitermaterial auf GaAs-Substrat, wobei die Gateelektrode einen Gatefuß und einen Gatekopf aufweist und in Richtung senkrecht zur Ebene der Halbleiterschicht aus mehreren Schichten (G1,G2,G3) besteht und
- eine erste Schicht (G1) aus Aluminium besteht und eine erste Schichtdicke (D1) aufweist,
- eine auf die erste Schicht (G1) folgende zweite Schicht (G2) aus einem von Aluminium verschiedenen zweiten Metall besteht,
- Aluminium als von dem Metall der zweiten Schicht verschiedenes weiteres Metall wenigstens eine weitere Schicht (G3) über der zweiten Schicht bildet und
- die mittlere Korngröße des Aluminiums in der ersten Schicht (G1) geringer ist als in der weiteren Schicht (G3).

16. Halbleiterbauelement nach Anspruch 15, **dadurch gekennzeichnet, dass** die erste Schichtdicke (D1)nicht größer als das 1,5-fache der Gatelänge, insbesondere nicht größer als die Gatelänge (GL) ist.

17. Halbleiterbauelement nach Anspruch 15 oder 16, **dadurch gekennzeichnet, dass** die erste Schichtdicke (D1) zwischen 10 nm und 100 nm liegt.

18. Halbleiterbauelement nach einem der Ansprüche 15 bis 17, **dadurch gekennzeichnet, dass** der Gatefuss in einem Recessgraben (RC) angeordnet ist.

19. Halbleiterbauelement nach Anspruch 18, **dadurch gekennzeichnet, dass** die erste Schichtdicke (D1) wenigstens 50 %, vorzugsweise wenigstens 65 %, insbesondere wenigstens 75 % der Tiefe (DR) des Recessgrabens beträgt.

20. Halbleiterbauelement nach einem der Ansprüche 15 bis 19, **dadurch gekennzeichnet, dass** das Metall der zweiten Schicht mit dem Al der ersten Schicht an der Grenzfläche zwischen erster und zweiter Schicht eine Legierung bildet.

21. Halbleiterbauelement nach Anspruch 20, **dadurch gekennzeichnet, dass** die Legierung von der Halbleiterschicht (4) beabstandet ist.

22. Halbleiterbauelement nach Anspruch 20 oder 21, **dadurch gekennzeichnet, dass** die zweite Schicht Ti, Ni oder Pt enthält.

23. Halbleiterbauelement nach einem der Ansprüche 15 bis 22, **dadurch gekennzeichnet, dass** die zweite Schichtdicke (D2) der zweiten Schicht (G2) geringer ist als die erste Schichtdicke (D1).

24. Halbleiterbauelement nach Anspruch 23, **dadurch gekennzeichnet, dass** die zweite Schichtdicke (D2) weniger als 10 nm, insbesondere weniger als 5 nm, vorzugsweise weniger als 2,5 nm beträgt.

25. Halbleiterbauelement nach einem der Ansprüche 15 bis 24, **dadurch gekennzeichnet, dass** der Gatekopf überwiegend durch die weitere Schicht (G3) gebildet ist.

26. Halbleiterbauelement nach einem der Ansprüche 15 bis 25, **dadurch gekennzeichnet, dass** die Schichtdicke (D3) der weiteren Schicht (G3) größer ist als die Summe der Schichtdicken von erster und zweiter Schicht (D1,D2).

27. Halbleiterbauelement nach einem der Ansprüche 15 bis 27, **dadurch gekennzeichnet, dass** die mittlere Korngröße des Aluminiums in der ersten Schicht weniger als 50 %, insbesondere weniger als 20 % der mittleren Korngröße in der weiteren Schicht beträgt.

## Claims

1. Method for producing a semiconductor component comprising a metallic gate electrode deposited on a semiconductor layer (4) on a compound semiconductor substrate (1) and having a gate foot and a gate head, wherein
- a first layer (G1) of the gate electrode is produced from aluminium on the semiconductor layer (4),
- a second layer (G2) composed of a second metal is deposited on the first layer (G1),
- as a further metal different from the second metal, at least predominantly aluminium is deposited in at least one further layer (G3) on the second layer, and
- after the deposition of the metal of the gate electrode, a temperature treatment at elevated temperature is carried out, during which grain size growth occurs in the aluminium and the growth of the grain sizes of the aluminium in the first layer is limited by the metal of the second layer to an average grain size which is less than the average grain size in the further layer.

2. Method according to Claim 1, **characterized in that** the first layer is deposited with a first layer thickness (D1), which is not more than 1.5 times the gate length, in particular not more than the gate length itself.

3. Method according to Claim 1 or 2, **characterized in that** the first layer is deposited with a first layer thickness (D1) of between 10 nm and 100 nm.

4. Method according to any of Claims 1 to 3, **characterized in that** a metal which can form an alloy with Al is chosen for the second layer, and **in that** Al and the metal of the second layer are alloyed at the interface of the first and second layers during the temperature treatment.

5. Method according to Claim 4, **characterized in that** the second layer (G2) is produced from Ti, Ni or Pt.

6. Method according to any of Claims 1 to 5, **characterized in that** the second layer (G2) is deposited with a second layer thickness (D2), which is less than the first layer thickness (D1).

7. Method according to Claim 6, **characterized in that** the second layer is deposited with a layer thickness (D2) of less than 10 nm, in particular less than 5 nm, preferably less than 2.5 nm.

8. Method according to any of Claims 1 to 7, **characterized in that** the gate head is predominantly produced from the further metal.

9. Method according to any of Claims 1 to 8, **characterized in that** the further metal is deposited with a layer thickness (D3) greater than the sum of the first and second layer thicknesses (D1, D2).

10. Method according to any of Claims 1 to 9, **characterized in that** exclusively aluminium is deposited as further metal.

11. Method according to any of Claims 1 to 10, **characterized in that** the plurality of metallic layers (G1, G2, G3) of the gate electrode are deposited by vapour deposition or cathode sputtering.

12. Method according to any of Claims 1 to 11, **characterized in that** the gate foot is deposited through an opening (MF) of an undercut layer in a recess trench (RC).

13. Method according to Claim 12, **characterized in that** the first layer is deposited with a first layer thickness that is at least 50%, in particular at least 65%, preferably at least 75%, of the depth (DR) of the recess trench (RC).

14. Method according to any of Claims 11 to 13, **characterized in that** the gate head is produced in the lift-off method.

15. Semiconductor component comprising a metallic gate electrode on a semiconductor layer composed of semiconductor material on a GaAs substrate, wherein the gate electrode has a gate foot and a gate head and consists of a plurality of layers (G1, G2, G3) in a direction perpendicular to the plane of the semiconductor layer, and
- a first layer (G1) consists of aluminium and has a first layer thickness (D1),
- a second layer (G2) succeeding the first layer (G1) consists of a second metal, which is different from aluminium,
- aluminium as further metal different from the metal of the second layer forms at least one further layer (G3) above the second layer, and
- the average grain size of the aluminium in the first layer (G1) is less than in the further layer (G3).

16. Semiconductor component according to Claim 15, **characterized in that** the first layer thickness (D1) is not greater than 1.5 times the gate length, in particular not greater than the gate length (GL).

17. Semiconductor component according to Claim 15 or 16, **characterized in that** the first layer thickness (D1) is between 10 nm and 100 nm.

18. Semiconductor component according to any of Claims 15 to 17, **characterized in that** the gate foot is arranged in a recess trench (RC).

19. Semiconductor component according to Claim 18, **characterized in that** the first layer thickness (D1) is at least 50%, preferably at least 65%, in particular at least 75%, of the depth (DR) of the recess trench.

20. Semiconductor component according to any of Claims 15 to 19, **characterized in that** the metal of the second layer forms an alloy with the Al of the first layer at the interface between the first and second layers.

21. Semiconductor component according to Claim 20, **characterized in that** the alloy is spaced apart from the semiconductor layer (4).

22. Semiconductor component according to Claim 20 or 21, **characterized in that** the second layer contains Ti, Ni or Pt.

23. Semiconductor component according to any of Claims 15 to 22, **characterized in that** the second layer thickness (D2) of the second layer (G2) is less than the first layer thickness (D1).

24. Semiconductor component according to Claim 23, **characterized in that** the second layer thickness (D2) is less than 10 nm, in particular less than 5 nm, preferably less than 2.5 nm.

25. Semiconductor component according to any of Claims 15 to 24, **characterized in that** the gate head is predominantly formed by the further layer (G3).

26. Semiconductor component according to any of Claims 15 to 25, **characterized in that** the layer thickness (D3) of the further layer (G3) is greater than the sum of the layer thicknesses of the first and second layers (D1, D2).

27. Semiconductor component according to any of Claims 15 to 27, **characterized in that** the average grain size of the aluminium in the first layer is less than 50%, in particular less than 20%, of the average grain size in the further layer.

## Revendications

1. Procédé de fabrication d'un composant semi-conducteur qui présente une électrode métallique de grille déposée sur une couche semi-conductrice (4) d'un substrat semi-conducteur de liaison (1), l'électrode de grille présentant un pied de grille et une tête de grille,
une première couche (G1) de l'électrode de grille étant réalisée sur la couche semi-conductrice (4) en aluminium,
une deuxième couche (G2) en un deuxième métal étant déposée sur la première couche (G1),
comme autre métal différent du deuxième métal, au moins principalement de l'aluminium est déposé dans au moins une autre couche (G3) située sur la deuxième couche,
après dépôt du métal de l'électrode de grille, un traitement thermique à haute température dans lequel a lieu une croissance de la taille des grains d'aluminium est conduit, la croissance de la taille des grains d'aluminium dans la première couche étant limitée par le métal de la deuxième couche à une taille moyenne de grains plus petite que la taille moyenne des grains de l'autre couche.

2. Procédé selon la revendication 1, **caractérisé en ce que** la première couche est déposée à une première épaisseur (D1) qui ne représente pas plus de 1,5 fois la longueur de la grille et en particulier pas plus que la longueur proprement dite de la grille.

3. Procédé selon les revendications 1 ou 2, **caractérisé en ce que** la première couche est déposée à une épaisseur (D1) comprise entre 10 nm et 100 nm.

4. Procédé selon l'une des revendications 1 à 3, **caractérisé en ce que** l'on sélectionne pour la deuxième couche un métal qui peut former un alliage avec Al et **en ce que** lors du traitement thermique, Al et le métal de la deuxième couche s'allient à la surface frontière entre la première et la deuxième couche.

5. Procédé selon la revendication 4, **caractérisé en ce que** la deuxième couche (G2) est réalisée en Ti, Ni ou Pt.

6. Procédé selon l'une des revendications 1 à 5, **caractérisé en ce que** la deuxième couche (G2) est déposée à une deuxième épaisseur (D2) inférieure à la première épaisseur (D1).

7. Procédé selon la revendication 6, **caractérisé en ce que** la deuxième couche est déposée à une épaisseur (D2) inférieure à 10 nm, en particulier inférieure à 5 nm et de préférence inférieure à 2,5 nm.

8. Procédé selon l'une des revendications 1 à 7, **caractérisé en ce que** la tête de la grille est principalement constituée de l'autre métal.

9. Procédé selon l'une des revendications 1 à 8, **caractérisé en ce que** l'autre métal est déposé en une couche d'épaisseur (D3) supérieure à la somme des épaisseurs (D1, D2) de la première et de la deuxième couche.

10. Procédé selon l'une des revendications 1 à 9, **caractérisé en ce que** comme autre métal, seul de l'aluminium est déposé.

11. Procédé selon l'une des revendications 1 à 10, **caractérisé en ce que** les différentes couches métalliques (G1, G2, G3) de l'électrode de grille sont déposées par vaporisation ou par pulvérisation cathodique.

12. Procédé selon l'une des revendications 1 à 11, **caractérisé en ce que** le pied de la grille est déposé dans un sillon en creux (RC) à travers une ouverture (MF) ménagée dans une couche non gravée.

13. Procédé selon la revendication 12, **caractérisé en ce que** la première couche est déposée à une première épaisseur qui représente au moins 50 %, en particulier au moins 65 %, et de préférence au moins 75 % de la profondeur (DR) du sillon en creux (RC).

14. Procédé selon l'une des revendications 11 à 13, **caractérisé en ce que** la tête de la grille est réalisée par un procédé de relèvement.

15. Elément semi-conducteur doté d'une électrode métallique de grille sur une couche semi-conductrice en un matériau semi-conducteur disposée sur un substrat de GaAs, l'électrode de grille présentant un pied de grille et une tête de grille et étant constituée de plusieurs couches (G1, G2, G3) dans la direction perpendiculaire au plan de la couche semi-conductrice,
une première couche (G1) étant constituée d'aluminium et présentant une première épaisseur (D1),
une deuxième couche (G2) suivant la première couche (G1) étant constituée d'un deuxième métal différent de l'aluminium,
l'aluminium constituant l'autre métal différent du métal de la deuxième couche formant au moins une autre couche (G3) au-dessus de la deuxième couche et
la taille moyenne des grains de l'aluminium dans la première couche (G1) étant inférieure à cette taille dans l'autre couche (G3).

16. Elément semi-conducteur selon la revendication 15, **caractérisé en ce que** l'épaisseur (D1) de la première couche n'est pas supérieure à 1,5 fois la longueur de la grille et en particulier n'est pas supérieure à la longueur (GL) de la grille.

17. Elément semi-conducteur selon les revendications 15 ou 16, **caractérisé en ce que** l'épaisseur (D1) de la première couche est comprise entre 10 nm et 100 nm.

18. Elément semi-conducteur selon l'une des revendications 15 à 17, **caractérisé en ce que** le pied de la grille est disposé dans un sillon en creux (RC).

19. Elément semi-conducteur selon la revendication 18, **caractérisé en ce que** l'épaisseur (D1) de la première couche représente au moins 50 %, de préférence au moins 65 % et en particulier au moins 75 % de la profondeur (DR) du sillon en creux.

20. Elément semi-conducteur selon l'une des revendications 15 à 19, **caractérisé en ce que** le métal de la deuxième couche forme avec Al de la première couche un alliage à la surface frontière entre la première et la deuxième couche.

21. Elément semi-conducteur selon la revendication 20, **caractérisé en ce que** l'alliage est maintenu à distance de la couche semi-conductrice (4).

22. Elément semi-conducteur selon les revendications 20 ou 21, **caractérisé en ce que** la deuxième couche contient Ti, Ni ou Pt.

23. Elément semi-conducteur selon l'une des revendications 15 à 22, **caractérisé en ce que** l'épaisseur (D2) de la deuxième couche (G2) est inférieure à l'épaisseur (D1) de la première couche.

24. Elément semi-conducteur selon la revendication 23, **caractérisé en ce que** l'épaisseur (D2) de la deuxième couche est inférieure à 10 nm, en particulier inférieure à 5 nm et de préférence inférieure à 2,5 nm.

25. Elément semi-conducteur selon l'une des revendications 15 à 24, **caractérisé en ce que** la tête de la grille est formée principalement par l'autre couche (G3).

26. Elément semi-conducteur selon l'une des revendications 15 à 25, **caractérisé en ce que** l'épaisseur (D3) de l'autre couche (G3) est supérieure à la somme des épaisseurs (D1, D2) de la première et de la deuxième couche.

27. Elément semi-conducteur selon l'une des revendications 15 à 27, **caractérisé en ce que** la taille moyenne des grains de l'aluminium de la première couche représente moins de 50 % et en particulier moins de 20 % de la taille moyenne des grains dans l'autre couche.
